(19)

Europäisches
Patentamt

European
Patent Office

Office européen
des brevets

(11) **EP 2 447 233 A1**

(12) **EUROPEAN PATENT APPLICATION**

(43) Date of publication:
**02.05.2012 Bulletin 2012/18**

(51) Int Cl.:
*C04B 35/457* [(2006.01)]  *C04B 38/00* [(2006.01)]

(21) Application number: **10189040.8**

(22) Date of filing: **27.10.2010**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Corning Incorporated
Corning NY 14831 (US)**

(72) Inventor: **Nazaraly, Micaela
93150, Le Blanc Mesnil (FR)**

(74) Representative: **Nevant, Marc
Cabinet Beau de Loménie
158, rue de l'Université
75340 Paris Cedex 07 (FR)**

(54) **Tin oxide-based thermoelectric materials**

(57)    The present invention relates to a thermoelectric material comprising a zinc-and tin-based oxide doped with a metal selected from Ta and Nb. The invention also relates to a thermoelectric device comprising such a thermoelectric material, and its use for waste heat recovery.

**EP 2 447 233 A1**

**Description**

**Technical field of the invention**

The present invention relates to doped tin-based oxides and to their use as thermoelectric materials, in particular in the field of automobile engines.

**Background of the invention**

Roughly a third of the energy consumed by the manufacturing industry is discharged as thermal losses to the atmosphere or to cooling systems. These discharges are the result of process inefficiencies and the inability of the manufacturing plants to utilize the excess energy. A portion of the waste heat is considered to be an opportunity for waste heat recovery, and thermoelectric technologies are being considered to recover and convert the industrial process waste energy to useful electrical energy.

Thermoelectric materials, discovered in 1821, are semiconductor solids that produce an electric current when joined together and subjected to a temperature difference across the junction. Fundamentally, thermoelectricity is concerned with the so-called Seebeck and Peltier effects. The first of these arises because of the property of certain materials, which creates an electrical potential V (expressed in Volts) between the ends of a solid submitted to a thermal gradient $\Delta T$ (expressed in degrees Kelvin). The Seebeck coefficient (S) is a measure of this induced electrical potential per the equation:

$$S = V / \Delta T$$

and is usually expressed in $\mu V/K$.

The Seebeck coefficient may be positive (p material) or negative (n material) depending on the nature and mobility of the charge carriers in the solid. This property is generally used to collect electrical energy from sources of heat. The Peltier effect is the opposite phenomenon, namely the creation of a temperature gradient in a material submitted to an electrical potential. It is generally exploited in cooling devices. For energy production, several n and p pairs of materials must usually be assembled in series in order to produce enough voltage for the required application.

From the material point of view, the properties required to allow making an efficient thermoelectric generator are:

-    a high Seebeck S absolute value either for p (+) or n (-) material for a significant voltage;
-    a high electrical conductivity $\sigma$, in order to deliver enough intensity;
-    a low thermal conductivity K, in order to maintain the thermal gradient at the origin of the voltage obtained.

To express the combination of the requirements on the three previously defined parameters, a figure of merit (ZT) of a material can be expressed in the form of:

$$ZT = \frac{S^2 \sigma}{K} \, T,$$

where S is the Seebeck coefficient of the material (V/K), $\sigma$ is the electrical conductivity of the material (A/V.m) and K is the thermal conductivity of the material (W/m.K).

Many materials already exist that could be used as thermoelectric materials. For example, skutterudite (Yang et al. 2004a; Kitagawa et al. 2000; Yang et al. 2004b) or $Bi_2Te_3$ (Ji et al. 2005; Seo et al. 2000) have high performances, but these materials have certain drawbacks such as the use temperature, the presence of toxic elements, the high price of the elements, and are therefore suitable to demonstrate the feasibility of the concept but not for long term applications.

Oxides are considered to be promising alternative materials, since they are stable at high temperature in air, are safe, green and inexpensive. The thermoelectric performance of ZnO-doped materials (ZT = 0.47 at 1000K; see Ohtaki et al. 1996) and more recently of layered cobalt oxide $Ca_3Co_4O_9$ (ZT = 0.22 at 1000K; see Zhang et al. 2008), has fostered research on thermoelectric materials based on oxides.

The formation of pores into oxides has been reported to increase their thermoelectric performances: see e.g. US2007/0240749, US5525162, WO2007/022456, JP10041556, JP2008108876, JP11097751. In these documents, however, the optimal size of the pore former particles used has never been studied. In some patent documents, the pore former particles are nanometric, in others, the size is less than 100$\mu$m or not really described.

Tin oxide, $SnO_2$, is a typical conductive oxide, which is used in many applications like gas sensors, transparent electrodes and varistors for example. The conduction type of $SnO_2$ is the n-type. Doping $SnO_2$ with $Sb_2O_5$ has been reported to increase the electrical conductivity, and the introduction of titanium oxide, $TiO_2$, has been shown to play a role in the thermoelectric properties, since the solubility of $TiO_2$ into $SnO_2$ introduces variations of the band gap (Tsubota et al. 2008). However, for this specific system, the thermoelectric performances are too low to be industrially used.

**Summary of the invention**

The present invention is based on the discovery of a tin- and zinc-based oxide material in which a secondary phase, $ZnSn_2O_4$, is present. Without wishing to be bound by theory, it is believed that the presence of this secondary phase, which is weakly conductive, decreases the thermal conductivity of the oxide material.

According to one aspect of the present invention, a thermoelectric material is therefore provided which comprises a matrix of a tin- and zinc-based oxide with regions of $ZnSn_2O_4$ dispersed therein.

In another aspect, the present invention provides a method of forming such a tin- and zinc-based oxide.

In a further aspect, the present invention provides a thermoelectric device incorporating the oxide defined above.

**Brief description of the drawings**

Figure 1 shows the power factor of the $SnO_2/M_2O_5$ oxide (M=Ta, Nb).
Figure 2 shows the power factor of the $SnO_2/ZnO$ oxide.
Figure 3 shows the Seebeck coefficient of the oxides of examples 1 and 2.
Figure 4 shows the electrical conductivity of the oxides of examples 1 and 2.
Figure 5 shows the thermal conductivity of the oxides of examples 1 and 2.
Figure 6 shows the power factor of the oxides of examples 1 and 2.
Figure 7 shows the figure of merit of the oxides of examples 1 and 2.
Figure 8 shows the Seebeck coefficient of the oxides of examples 1, 3 and 4.
Figure 9 shows the electrical conductivity of the oxides of examples 1, 3 and 4.
Figure 10 shows the power factor of the oxides of examples 1, 3 and 4.
Figure 11 shows the thermal conductivity of the oxides of examples 1, 3 and 4.
Figure 12 shows the figure of merit of the oxides of examples 1, 3 and 4.
Figure 13 shows the power factor of the oxides of examples 2 and 5 to 8.
Figure 14 shows the figure of merit of the oxides of examples 2 and 5 to 8.
Figure 15 shows the power factor of the oxides of examples 1,4, 9 and 10.
Figure 16 shows the figure of merit of the oxides of examples 1, 4, 9 and 10.

**Detailed Description of the Invention**

In one aspect, the present invention relates to a thermoelectric material comprising a matrix of a tin- and zinc-based oxide material, in which regions of $ZnSn_2O_4$ are dispersed. The oxide can be represented by the formula $Sn_{1-x-y}Zn_xM_yO_2$ in which M is selected from Ta and Nb and x and y are each different from 0 and are such that $0.76 \leq 1-x-y \leq 0.99$. x and y, which represent the weight percent of Zn and M, respectively, are preferably such that $0.765 \leq 1-x-y \leq 0.985$.

The amount of secondary phase, $ZnSn_2O_4$, present in the oxide is in the range of from about 1 wt% to about 25 wt%, preferably in the range of from about 5 wt% to about 20 wt%, based on the total weight of the thermoelectric material.

In another aspect, the present invention relates to a thermoelectric material which can be obtained by a process comprising the steps of:

a) preparing a mixture of powders of $SnO_2$ ZnO and $M_2O_5$, wherein M is as defined above;
b) sintering the resulting mixture at a temperature in the range of from about 1000 °C to about 1400 °C, preferably in the range of from about 1200 °C to about 1400 °C.

In one embodiment, the thermoelectric material has the formula shown above.

In another embodiment, which can be combined with the previous embodiment, the mixture of oxide powders comprises:

- from about 85 wt% to about 95 wt%, preferably from about 90 wt% to about 95 wt% $SnO_2$;
- from about 2.5 wt% to about 15 wt%, preferably from about 5 wt% to about 10 wt% ZnO; and
- from about 0.05 wt% to about 5 wt%, preferably from about 0.1 wt% to about 2 wt% $M_2O_5$;

it being understood that the sum of the amounts of $SnO_2$ ZnO and $M_2O_5$ is 100 %.

The starting oxide powders can be mixed by any conventional means, e.g. by hand, in a tumble or by attrition in a suitable medium such as an ethanol medium. In the latter case, the attrited mixture is dried, e.g. in an oven, before sintering.

The mixture of powders is preferably pressed into pellets before sintering. This is generally achieved using a suitable binder such as for example polyvinyl alcohol.

The relative density of the sintered oxides is in the range of about 85% to 95%, i.e. the oxides are low porosity materials.

In yet another embodiment, which can be combined with one or more of the previous embodiments, a pore former is added to the powders of $SnO_2$, ZnO and $M_2O_5$ before sintering. The pore former is added in an amount such that the weight ratio of the pore former to the combined oxide powders is in the range of from about 5/95 to about 15/85. The combined oxide powders comprise from about 85 wt% to about 95 wt%, preferably from about 90 wt% to about 95 wt% $SnO_2$; from about 5 wt% to about 15 wt%, preferably from about 5 wt% to about 10 wt% ZnO; and from about 0.01 wt% to about 0.5 wt%, preferably from about 0.05 wt% to 0.2 wt% $M_2O_5$; it being understood that the sum of the amounts of $SnO_2$, ZnO and $M_2O_5$ is 100%.

The particle size of the pore former is typically in the range of from about 100 nm to about 100 $\mu$m, preferably in the range of from about 5 $\mu$m to about 70 $\mu$m, more preferably in the range of from about 20 $\mu$m to about 60 $\mu$m. Suitable pore formers include potato starch and graphite.

The pore former can be mixed with the oxide powders by simple mixing, e.g. by hand or in a tumble, and the resulting mixture is sintered. Alternately, the oxide powders are attrited in a suitable medium as described above, the resulting mixture is dried and the dried powder is mixed with the pore former. In both alternatives, the mixture of oxide powders and pore former is preferably pressed into pellets before sintering.

Without wishing to be bound by theory, the pore former is removed during sintering (owing to the high temperatures used) thus creating porosity. The resulting oxides have a relative density in the range of from about 55% to about 75%, preferably in the range of from about 60% to about 70%.

The oxides of the present invention exhibit good thermoelectric properties. Increasing the porosity (i.e. decreasing the relative density) of the oxides made it possible to decrease the thermal conductivity by a factor of about 10, with a maximum figure of merit obtained of about 0.16 at 1000K. Such a value is excellent for a $SnO_2$-based oxide and allows for such an oxide to be used as a thermoelectric material of the n-type.

Thermoelectric devices comprise a thermoelectric material of the n-type (having a negative Seebeck coefficient) and a thermoelectric material of the p-type (having a positive Seebeck coefficient). The n-type thermoelectric material of the present invention can be used as a part of a thermoelectric device.

In another aspect, the present invention therefore relates to a thermoelectric device comprising a thermoelectric material as defined above. One of the most interesting short term applications of thermoelectric devices is waste heat recovery, in particular waste heat recovery of automobile engines. Indeed, vehicles require more and more electricity for different security and comfort devices, whereas more than 30 % of the energy produced from the fuel is lost as waste heat. Waste heat recovery can be used to produce electricity using a thermoelectric device, leading to decreased fuel consumption and consequently to decreased $CO_2$ emissions.

In the following examples, which illustrate the invention, commercially available powders of $SnO_2$, ZnO and $Ta_2O_5$ or $Nb_2O_5$ were used as starting materials. The different oxides were prepared by solid state reaction using the general procedure described below, unless otherwise mentioned:

a) pre-determined amounts of the starting oxide powders were mixed, e.g. by hand or in a tumble;
b) the resulting mixture was pressed into pellets in the presence of polyvinyl alcohol as a binder (Rodoviol®, available from VWR International SAS, France); and
c) the pellets were sintered at 1350°C for 1h (at a heating rate of 20°C/h until 500°C and then 100°C/h until 1350°C) then cooled to room temperature (at a cooling rate of 50°C/h).

Square bars were cut from the pellets and used for the measurement of density, electrical conductivity and Seebeck coefficient; a disc of 12.7 mm diameter was cut from the pellets for the measurement of thermal conductivity.

XRD data were collected using a Philips X-Pert Pro diffractometer with the following configuration: X-celerator detector, copper anode, 45kV, 40mA, A=1.540593, $2\theta$: 10 to 140°, step: 0.017°, time by step: 40s.

The electrical conductivity and the Seebeck coefficient were measured using a ULVAC-RIKO ZEM3 device between 600 and 1100 K under helium. The thermal conductivity was determined from the thermal diffusivity and specific heat capacity measured using a Netzsch model 457 MicroflashTM apparatus and a Netzsch Phoenix apparatus, respectively.

The relative density of an oxide is the ratio of its experimental density (determined from a square bar cut from the pellets as explained above; d = mass of bar / unit volume of bar) to that of its theoretical density, determined by X-ray diffraction. Porosity is the percentage of void volume in an oxide. It is the converse of density. An oxide which has 85% relative density has 15% porosity.

Reference Example 1: synthesis and properties of a $SnO_2/M_2O_5$ oxide (M=Ta, Nb)

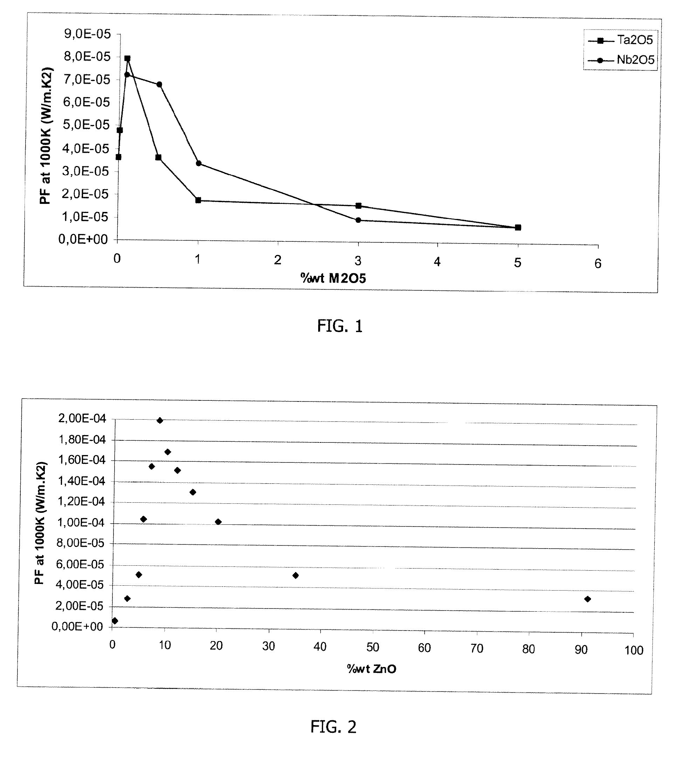

Different oxides were prepared from a mixture of powders of $SnO_2$ and $M_2O_5$ (M=Ta or Nb) following the general procedure described above. The power factor (PF) of the oxides was determined at 1000K. The PF results of the different $SnO_2/M_2O_5$ oxides are shown in Table 1 and Figure 1. It can be seen that the amount of starting $M_2O_5$ has a significant impact on the power factor of the resulting oxide. Both Seebeck coefficient and electrical conductivity are impacted. The power factor of the oxide is maximum when the mixture of powders comprises 99.9 wt% $SnO_2$ and 0.1 wt% $M_2O_5$.

Table 1

| wt% $M_2O_5$ | PF oxide (M = Ta) (W/m.K$^2$) | PF oxide (M = Nb) (W/m.K$^2$) |
|---|---|---|
| 0.005 | $3.60*10^{-5}$ | - |
| 0.01 | $4.77*10^{-5}$ | - |
| 0.1 | $7.92*10^{-5}$ | $7.23*10^{-5}$ |
| 0.5 | $3.62*10^{-5}$ | $6.80*10^{-5}$ |
| 1 | $1.76*10^{-5}$ | $3.34*10^{-5}$ |
| 3 | $1.58*10^{-5}$ | $9.60*10^{-6}$ |
| 5 | $7.06*10^{-6}$ | $7.16*10^{-6}$ |

Reference example 2: synthesis and properties of a $SnO_2$/ZnO oxide

Different oxides were prepared from a mixture of powders of $SnO_2$ and ZnO following the general procedure described above. The power factor of the oxides was determined at 1000K. The PF results of the different $SnO_2$/ZnO oxides are shown in Table 2 and Figure 2. It can be seen that the amount of starting ZnO has a significant impact on the power factor of the resulting oxide. Both Seebeck coefficient and electrical conductivity are impacted. The power factor is maximum when the mixture of powders comprises 91.51 wt% $SnO_2$ and 8.49 wt% ZnO.

Table 2

| %wt ZnO | PF (W/m.K$^2$) |
|---|---|
| 0.54 | $5.8312*10^{-6}$ |
| 2.76 | $2.77*10^{-5}$ |
| 5 | $5.11*10^{-5}$ |
| 5.66 | $1.04*10^{-4}$ |
| 7 | $1.55*10^{-4}$ |
| 8.49 | $1.99*10^{-4}$ |
| 10 | $1.69*10^{-4}$ |
| 12 | $1.51*10^{-4}$ |
| 15 | $1.31*10^{-4}$ |
| 20 | $1.02*10^{-4}$ |
| 35.06 | $5.18*10^{-5}$ |
| 91.2 | $3.17*10^{-5}$ |

Example 1: synthesis and properties of a $SnO_2/ZnO/Ta_2O_5$ oxide

An oxide was prepared from a mixture comprising 91.4 wt% $SnO_2$ 8.5 wt% ZnO and 0.1 wt% $Ta_2O_5$ following the general procedure described above.

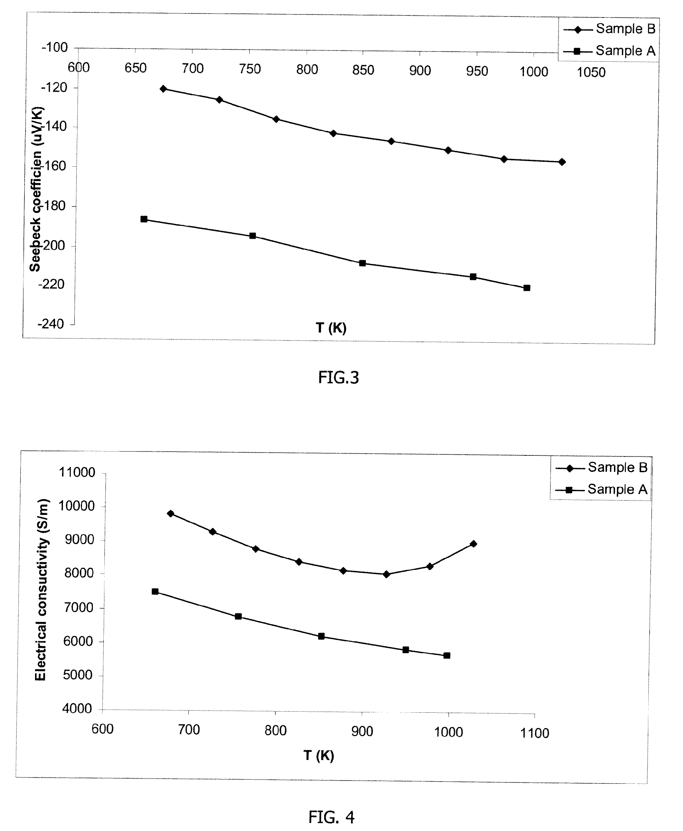

The Seebeck coefficient, electrical conductivity, thermal conductivity, power factor and figure of merit of the oxide were determined as a function of the temperature. The results are shown in Figures 3 to 7 (sample A). It can be seen from these figures that:

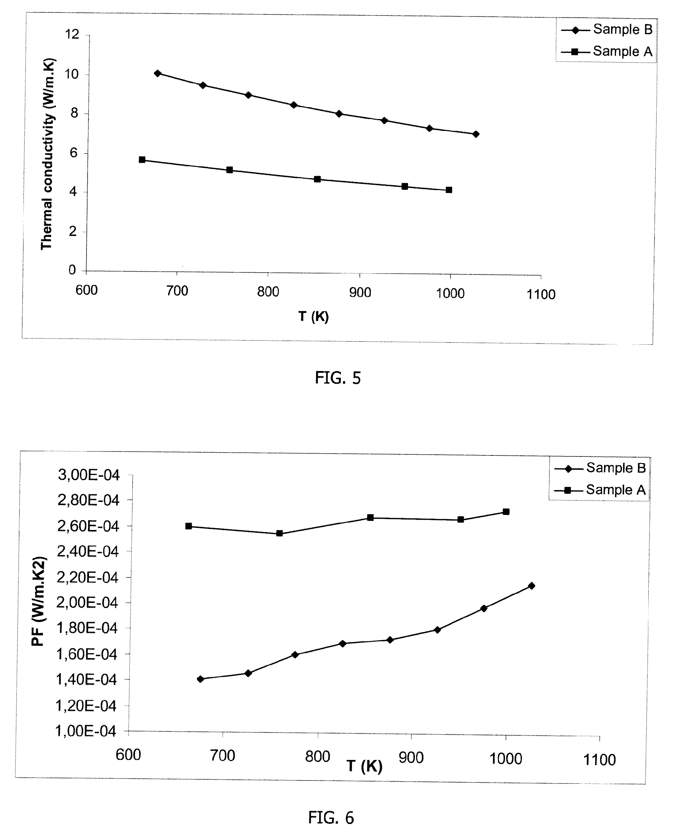

- the Seebeck coefficient is negative, which means that the oxide has n-type conduction, and ranges from -180 to -220 $\mu$V/K (Figure 3);
- the electrical and thermal conductivities decrease as the temperature increases (Figures 4 and 5);
- the PF and ZT are maximum at 1000K ($2.78*10^{-4}$ $W/m.K^2$ and 0.06, respectively).

The relative density of the oxide was 90%. XRD analysis of the oxide showed that a secondary phase, $ZnSn_2O_4$ was present in the oxide.

Example 2: synthesis and properties of a $SnO_2/ZnO/Ta_2O_5$ oxide

An oxide was prepared from a mixture comprising 93.5 wt% $SnO_2$, 5 wt% ZnO and 1.5 wt% $Ta_2O_5$ following the general procedure described above.

The Seebeck coefficient, electrical conductivity, thermal conductivity, power factor and figure of merit of the oxide were determined as a function of the temperature. The results are shown in Figures 3 to 7 (sample B). It can be seen from these figures that:

- the Seebeck coefficient is negative, which means that the oxide has n-type conduction, and ranges from -120 to -150 $\mu$V/K (Figure 3);
- the electrical conductivity shows an inflection point at about 950K whereas the thermal conductivity decreases as the temperature increases (Figures 4 and 5);
- the PF and ZT are maximum at 1000K ($2.22*10^{-4}$ $W/m.K^2$ and 0.03, respectively).

The relative density of the oxide was 90%. XRD analysis of the oxide showed that a secondary phase, $ZnSn_2O_4$ (5.3 wt%) was present in the oxide.

A comparison between the oxides of examples 1 and 2 shows that the absolute value of the Seebeck coefficient for example 1 is higher than for example 2; the power factor ($S^2*\sigma$) and ZT obtained for example 1 are also higher than for example 2.

Example 3: synthesis of a modified $SnO_2/ZnO/Ta_2O_5$ oxide

A mixture of oxide powders as described in example 1 (91.4 wt% $SnO_2$ 8.5 wt% ZnO and 0.1 wt% $Ta_2O_5$) was tumble mixed for 30 min with potato starch (having a particle size of 44 $\mu$m) as a pore former. The weight ratio of the mixture of oxide powders to the pore former was 90/10. The resulting mixture was pressed into pellets using polyvinyl alcohol as a binder (Rodoviol®, available from VWR International, France), and sintered at temperatures comprised between 650K and 1100K.

Example 4: synthesis a modified $SnO_2/ZnO/Ta_2O_5$ oxide

The procedure of example 3 was repeated, using graphite (having a particle size of 53 $\mu$m) as a pore former. An oxide was obtained having a relative density of 69%.

Test example 1: properties of modified $SnO_2/ZnO/Ta_2O_5$ oxides

The thermoelectric properties of the oxides of examples 3 and 4 were determined and compared to those of the oxide of example 1.

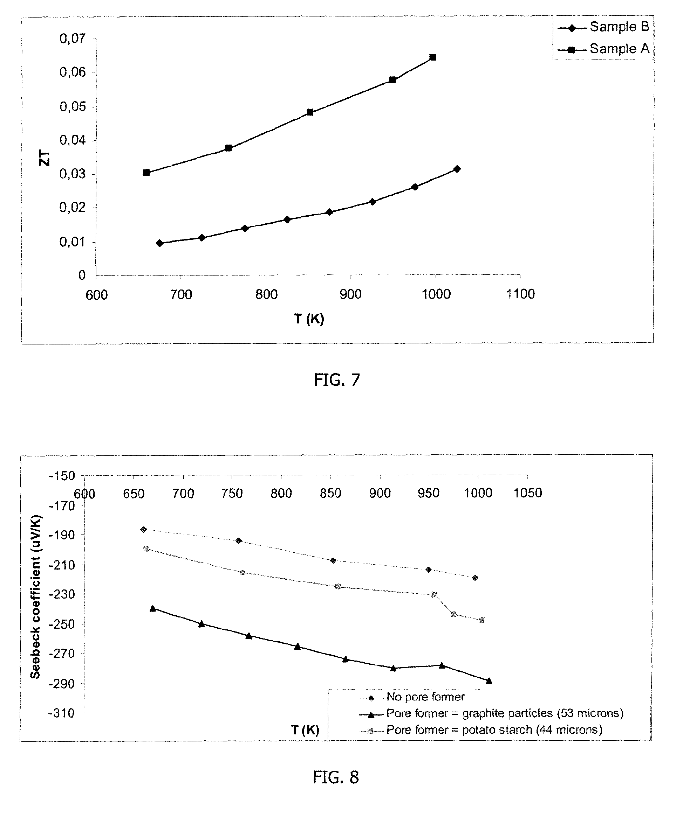

As can be seen from Figure 8, the introduction of porosity in the oxide has a positive impact on the Seebeck coefficient: a lower relative density for the oxide results in a higher (in absolute value) Seebeck coefficient (it is comprised between -230 $\mu$V/K and -290 $\mu$V/K when the pore former is graphite having a particle size of 53 $\mu$m).

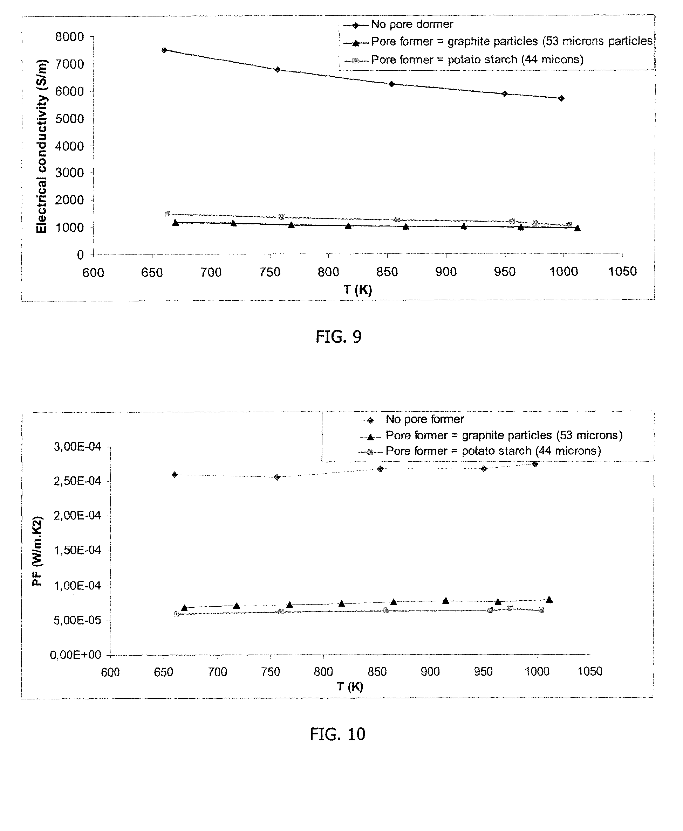

Conversely, the introduction of porosity in the oxide has a negative impact on the electrical conductivity (see Figure 9). In fact, the electrical conductivity is represented by the equation $\sigma = n * e * \mu$ where n is the carrier density, e is the charge carrier and $\mu$ is the mobility. A pore could be considered as a scattering center, the mobility $\mu$ is then decreased and leads to the decrease of the electrical conductivity. The power factor ($S^2*\sigma$) consequently decreases when porosity is introduced in the oxide (see Figure 10).

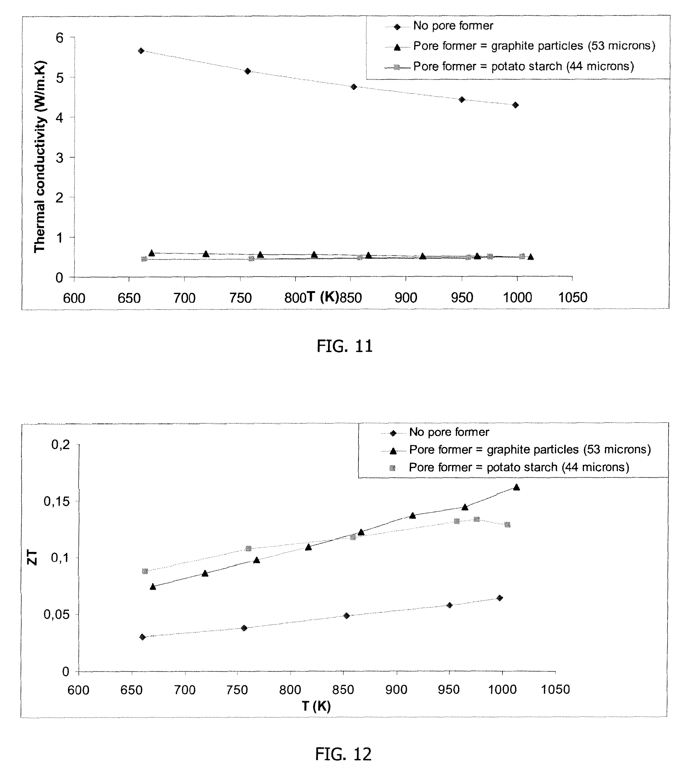

The main effect of the introduction of porosity is on the thermal conductivity which is positively impacted. As can be seen from Figure 11 the thermal conductivity significantly decreases at all sintering temperatures (e.g. from 4.27 W/m.K to 0.495 W/m.K at 1000K).

Since a low thermal conductivity is beneficial for the figure of merit (ZT), the latter is positively impacted by the introduction of porosity in the oxide. As can be seen from Figure 12, the ZT value is improved by 2- to 3-fold at 1000K when porosity is introduced in the oxide (0.064 for non-porous oxide vs 0.13 when the porosity is introduced by potato starch particles and 0.16 when porosity is introduced with graphite particles). To the inventor's knowledge, these values have never been obtained before for $SnO_2$-based systems.

Example 5: synthesis of a modified $SnO_2/ZnO/Ta_2O_2$ oxide

A mixture of oxide powders as described in example 2 (93.5 wt% $SnO_2$ 5 wt% ZnO and 1.5 wt% $Ta_2O_5$) was attrited with zircona balls in ethanol for 6 h, and then dried in an oven. The resulting dried powder was tumble-mixed with graphite (having a particle size of 100 nm) as a pore former in a 90/10 weight ratio. The resulting mixture was pressed into pellets using polyvinyl alcohol as a binder (Rodoviol®, available from VWR International, France), and sintered at 1000K. An oxide was obtained having a relative density of 66%.

Example 6: synthesis of a modified $SnO_2/ZnO/Ta_2O_5$ oxide

The procedure of example 5 was repeated, using graphite (having a particle size of 8 $\mu$m) as a pore former. An oxide was obtained having a relative density of 67%.

Example 7: synthesis of a modified $SnO_2/ZnO/Ta_2O_5$ oxide

The procedure of example 5 was repeated, using graphite (having a particle size of 26 $\mu$m) as a pore former. An oxide was obtained having a relative density of 77%.

Example 8: synthesis of a modified $SnO_2/ZnO/Ta_2O_5$ oxide

The procedure of example 5 was repeated, using graphite (having a particle size of 53 $\mu$m) as a pore former. An oxide was obtained having a relative density of 64%.

Test example 2: properties of modified $SnO_2/ZnO/Ta_2O_5$ oxides

The thermoelectric properties of the oxides of examples 5 to 8 were determined and compared to those of the oxide of example 2.

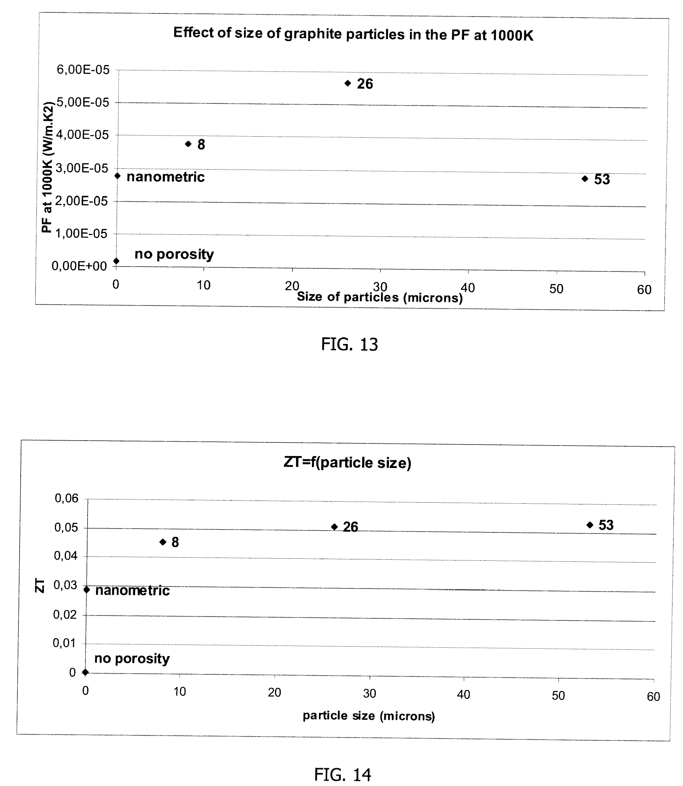

As can be seen from Table 3 and Figures 13 and 14, the highest ZT is obtained for example 8 where the particle size of the pore former is equal to 53 $\mu$m, even if the power factor for this particular value is not the highest.

Table 3

| Example | PF at 1000K (W/m.K$^2$) | ZT at 1000K |
|---------|------------------------|-------------|
| 2 | $1.66*10^{-6}$ | $3.49*10^{-4}$ |
| 5 | $2.76*10^{-5}$ | $2.89*10^{-2}$ |
| 6 | $3.76*10^{-5}$ | $4.54*10^{-2}$ |
| 7 | $5.65*10^{-5}$ | $5.11*10^{-2}$ |
| 8 | $2.83*10^{-5}$ | $5.29*10^{-2}$ |

Example 9: synthesis of a modified $SnO_2/ZnO/Ta_2O_5$ oxide

The procedure of example 3 was repeated, using graphite (having a particle size of 100 nm) as a pore former, and a sintering temperature of 1350 °C. An oxide was obtained having a relative density of 60%.

Example 10: synthesis of a modified $SnO_2/ZnO/Ta_2O_5$ oxide

The procedure of example 3 was repeated, using graphite (having a particle size of 8 $\mu$m) as a pore former, and a sintering temperature of 1350 °C. An oxide was obtained having a relative density of 70%.

Test example 3: properties of modified $SnO_2/ZnO/Ta_2O_5$ oxides

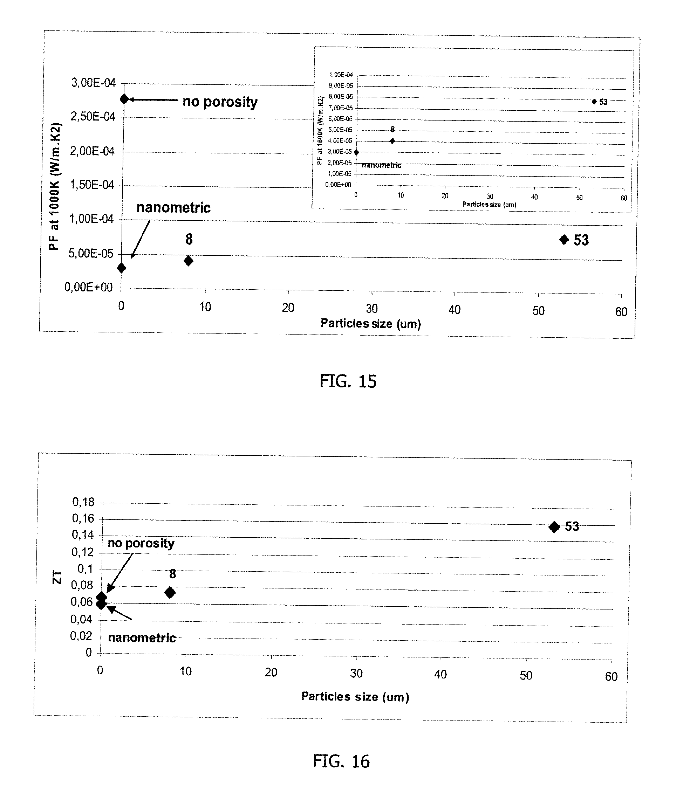

The thermoelectric properties of the oxides of examples 9 and 10 were determined and compared to those of the oxides of examples 1 and 4.
As can be seen from Table 4 and Figures 15 and 16 the highest ZT is obtained for example 4 where the particle size of the pore former is equal to 53 $\mu$m.

Table 4

| Example | PF at 1000K (W/m.K$^2$) | ZT at 1000K |
|---------|-------------------------|-------------|
| 1 | $2.78*10^{-4}$ | 0.0665 |
| 4 | $7.89*10^{-5}$ | 0.158 |
| 9 | $2.96*10^{-5}$ | 0.0586 |
| 10 | $4.05*10^{-5}$ | 0.0736 |

**REFERENCES**

1. L. Yang, J.S. Wu, L.T. Zhang, J. Alloys Compd. 375 (2004) 114
2. H. Kitagawa, M. Hasaka, T. Morimura, H. Nakashima, S. Kondo, Scripta Mater. 43 (2000) 727
3. L. Yang, J.S. Wu, L.T. Zhang, J. Alloys Compd. 364 (2004) 83
4. X.H. Ji, X.B. Zhao, Y.H. Zhang, B.H. Lu, H.L. Ni, J. Alloys Compd. 387 (2005) 282
5. J. Seo, C. Lee, K. Park, J. Mater. Sci. 35 (2000) 1549
6. Y. Zhang and J. Zhang, J. Of Materials and Processing Technologie, 208 (2008) 70-74
7. M. Ohtaki, T. Tsubota, K. Eguchi, H. Arai, J. Appl. Phys. 79 (1996) 1816
8. T. Tsubota et al., J. Of Alloys and Comp. 463 (2008) 288

**Claims**

1.  A thermoelectric material comprising a matrix of an oxide of the formula $Sn_{1-x-y}Zn_xM_yO_2$ in which regions of $ZnSn_2O_4$ are dispersed, wherein:

    M is a metal selected from Ta and Nb, and
    x and y, which represent the weight percent of Zn and M, respectively, are each different from 0 and are such that $0.76 \leq 1-x-y \leq 0.99$.

2.  The thermoelectric material of claim 1, wherein the amount of $ZnSn_2O_4$ therein is in the range of from about 1 wt% to about 25 wt%, preferably in the range of from about 5 wt% to about 20 wt%, based on the total weight of the material.

3.  The thermoelectric material of claim 1 or claim 2, which is obtainable by a process comprising the steps of:

    a) preparing a mixture comprising from about 85 wt% to about 95 wt% $SnO_2$, from about 2.5 wt% to about 15 wt% ZnO, and from about 0.05 wt% to about 5 wt% $M_2O_5$, wherein M is as defined in claim 1, it being understood that the sum of the amounts of $SnO_2$, ZnO and $M_2O_5$ is 100 %;
    b) sintering the resulting mixture at a temperature in the range of from about 1000 °C to about 1400 °C, preferably in the range of from about 1200 °C to about 1400 °C.

4. The thermoelectric material of claim 3, wherein the mixture in step a) comprises from about 90 wt% to about 95 wt% $SnO_2$, from about 5 wt% to about 10 wt% ZnO and from about 0.1 wt% to about 2 wt% $M_2O_5$, it being understood that the sum of the amounts of $SnO_2$, ZnO and $M_2O_5$ is 100 %.

5. The thermoelectric material of claim 3 or 4, wherein a pore former is added in step a) to the mixture of $SnO_2$, ZnO and $M_2O_5$, wherein the weight ratio of the pore former to the combined oxides is in the range of from about 5/95 to about 15/85.

6. The thermoelectric material according to claim 5, wherein the particle size of the pore former is in the range of from about 100 nm to about 100 $\mu$m, preferably in the range of from about 5 $\mu$m to about 70 $\mu$m.

7. The thermoelectric material of any one of claims 3 to 6, wherein the mixture of oxides and, when present, of the pore former, is pressed into pellets before sintering.

8. A process for preparing a thermoelectric material comprising the steps of:

   a) preparing a mixture comprising from about 85 wt% to about 95 wt% $SnO_2$, from about 2.5 wt% to about 15 wt% ZnO, and from about 0.05 wt% to about 5 wt% $M_2O_5$, wherein M is a metal selected from Ta and Nb, it being understood that the sum of the amounts of $SnO_2$, ZnO and $M_2O_5$ is 100 %;
   b) sintering the resulting mixture at a temperature in the range of from about 1000 °C to about 1400 °C, preferably in the range of from about 1200 °C to about 1400 °C.

9. The process of claim 8 wherein a pore former is added in step a) to the mixture of $SnO_2$, ZnO and $M_2O_5$, wherein the weight ratio of the pore former to the combined oxides is in the range of from about 5/95 to about 15/85.

10. A thermoelectric device comprising a thermoelectric material as defined in any one of claims 1 to 7.

11. Use of the thermoelectric device of claim 10 for the waste heat recovery of automobile engines.

FIG. 1

FIG. 2

FIG.3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

Europäisches
Patentamt

European
Patent Office

Office européen
des brevets

## EUROPEAN SEARCH REPORT

Application Number

EP 10 18 9040

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/108951 A1 (HASEGAWA AKIRA [JP] ET AL) 6 May 2010 (2010-05-06) * claims 1-6; examples 1,2 * ----- | 1-4,8,10 | INV. C04B35/457 C04B38/00 |
| X | EP 1 835 511 A2 (SUMITOMO METAL MINING CO [JP]) 19 September 2007 (2007-09-19) * claims 1-14; examples 1-23 * ----- | 1-4,8,10 | |
| X | CN 101 038 796 A (SUMITOMO METAL MINING CO [JP]) 19 September 2007 (2007-09-19) * claims 1-14; examples 1-23 * ----- | 1-4,8,10 | |
| A | JP 8 171824 A (GUNZE KK) 2 July 1996 (1996-07-02) * abstract * ----- | 1-11 | |
| A | US 2009/065746 A1 (HATTORI TAKESHI [JP] ET AL) 12 March 2009 (2009-03-12) * claims 1-7; examples 1,2 * ----- | 1-11 | |
| A | ENOKI H ET AL: "THE ELECTRICAL AND OPTICAL PROPERTIES OF THE ZNO-SNO2 THIN FILMS PREPARED BY RF MAGNETRON SPUTTERING", PHYSICA STATUS SOLIDI. A: APPLIED RESEARCH, WILEY - VCH VERLAG, BERLIN, DE, vol. 129, 1 January 1992 (1992-01-01), page 181, XP009036246, ISSN: 0031-8957 * the whole document * ----- | 1-11 | TECHNICAL FIELDS SEARCHED (IPC) C04B |

The present search report has been drawn up for all claims

| Place of search | Date of completion of the search | Examiner |
|---|---|---|
| The Hague | 21 March 2011 | Burtan, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 10 18 9040

This annex lists the patent family members relating to the patent documents cited in the above-mentioned European search report.
The members are as contained in the European Patent Office EDP file on
The European Patent Office is in no way liable for these particulars which are merely given for the purpose of information.

21-03-2011

| Patent document cited in search report | | Publication date | Patent family member(s) | | Publication date |
|---|---|---|---|---|---|
| US 2010108951 | A1 | 06-05-2010 | CN 101605735 A <br> JP 2008192604 A <br> WO 2008084865 A1 <br> KR 20090101365 A | | 16-12-2009 <br> 21-08-2008 <br> 17-07-2008 <br> 25-09-2009 |
| EP 1835511 | A2 | 19-09-2007 | JP 4552950 B2 <br> JP 2007277075 A <br> KR 20070093840 A <br> US 2007215456 A1 | | 29-09-2010 <br> 25-10-2007 <br> 19-09-2007 <br> 20-09-2007 |
| CN 101038796 | A | 19-09-2007 | NONE | | |
| JP 8171824 | A | 02-07-1996 | JP 3616128 B2 | | 02-02-2005 |
| US 2009065746 | A1 | 12-03-2009 | CN 101401169 A <br> JP 2007250369 A <br> WO 2007119497 A2 <br> KR 20080113054 A | | 01-04-2009 <br> 27-09-2007 <br> 25-10-2007 <br> 26-12-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070240749 A
- US 5525162 A
- WO 2007022456 A
- JP 10041556 B
- JP 2008108876 B
- JP 11097751 B

**Non-patent literature cited in the description**

- **L. YANG ; J.S. WU ; L.T. ZHANG.** *J. Alloys Compd.,* 2004, vol. 375, 114
- **H. KITAGAWA ; M. HASAKA ; T. MORIMURA ; H. NAKASHIMA ; S. KONDO.** *Scripta Mater.,* 2000, vol. 43, 727
- **L. YANG ; J.S. WU ; L.T. ZHANG.** *J. Alloys Compd.,* 2004, vol. 364, 83
- **X.H. JI ; X.B. ZHAO ; Y.H. ZHANG ; B.H. LU ; H.L. NI.** *J. Alloys Compd.,* 2005, vol. 387, 282
- **J. SEO ; C. LEE ; K. PARK.** *J. Mater. Sci.,* 2000, vol. 35, 1549
- **Y. ZHANG ; J. ZHANG.** *J. Of Materials and Processing Technologie,* 2008, vol. 208, 70-74
- **M. OHTAKI ; T. TSUBOTA ; K. EGUCHI ; H. ARAI.** *J. Appl. Phys.,* 1996, vol. 79, 1816
- **T. TSUBOTA et al.** *J. Of Alloys and Comp.,* 2008, vol. 463, 288